# EUROPÄISCHE PATENTSCHRIFT

(11) **EP 3 329 753 B1**
(45) Veröffentlichungstag und Bekanntmachung des Hinweises auf die Patenterteilung: **18.12.2019**
(21) Anmeldenummer: 16751596.4
(22) Anmeldetag: 16.08.2016
(51) Int. Cl.: H05K 7/14, H01G 9/15, H01G 4/40

(54) **ELEKTRISCHE SCHALTUNGSANORDNUNG MIT KONDENSATOR MIT GEHÄUSEFUNKTION**
ELECTRICAL CIRCUIT ASSEMBLY COMPRISING A CAPACITOR WITH HOUSING FUNCTION
AGENCEMENT DE CIRCUIT ELECTRIQUE DOTE DE CONDENSATEUR FAISANT FONCTION DE BOITIER

(30) Priorität: 23.09.2015 EP 15186521
(43) Veröffentlichungstag der Anmeldung: 06.06.2018
(73) Patentinhaber: Siemens Aktiengesellschaft, 80333 München (DE)
(72) Erfinder: BIGL, Thomas, 91074 Herzogenaurach (DE); HENSLER, Alexander, 90766 Fürth (DE); NEUGEBAUER, Stephan, 91058 Erlangen (DE); PFEFFERLEIN, Stefan, 90562 Heroldsberg (DE)
(86) Internationale Anmeldenummer: PCT/EP2016/069386
(87) Internationale Veröffentlichungsnummer: WO 2017/050489

(56) Entgegenhaltungen:
- EP-A1- 2 672 618
- WO-A1-2014/205474
- DE-C1- 4 443 498
- US-A1- 2009 231 812
- US-A1- 2010 321 859

## Beschreibung

Die vorliegende Erfindung betrifft eine elektrische Schaltungsanordnung gemäß dem Oberbegriff von Anspruch 1.

Elektrische Schaltungsanordnungen sind in vielfältigen Ausgestaltungen bekannt. Oftmals nehmen in derartigen elektrischen Schaltungsanordnungen Kondensatoren einen erheblichen Teil des Bauraums ein. Dies gilt insbesondere für Zwischenkreisumrichter, die oftmals eine große Kapazität zwischen Gleichrichter und Wechselrichter benötigen.

Die Kondensatoren des Standes der Technik sind oftmals nur schwer in die übrige Schaltungsanordnung integrierbar bzw. innerhalb eines Gehäuses anordenbar. Weiterhin müssen die Kondensatoren des Standes der Technik oftmals durch aufwändige Maßnahmen gegen mechanische Schwingungs- und Schockbelastungen gesichert werden. Ein weiterer Nachteil ist, dass insbesondere größere Kondensatoren oftmals nicht sehr nahe an schaltenden Elementen (beispielsweise den Halbleiterschaltern eines Gleichrichters oder eines Wechselrichters) angeordnet werden können. Eine nahe Anordnung wäre jedoch technisch vorteilhaft.

Im Stand der Technik sind die Kondensatoren meist als diskrete Bauelemente verbaut. Sie weisen oftmals eine zylindrische oder quaderförmige Gestalt auf und werden oftmals auf Flachbaugruppen aufgelötet oder mit Stromschienen verschraubt. Durch entsprechende Verbindungen mit der Baugruppe und manchmal auch mit einem umgebenden Gehäuse oder dergleichen (beispielsweise einem Schaltschrank) müssen sie mechanisch gesichert werden. Die Baugruppen selbst müssen eine hinreichende mechanische Steifigkeit und Stabilität aufweisen, damit sie die Kondensatoren tragen und sichern können.

Aus der US 2010/0 321 859 A1 ist eine elektrische Schaltungsanordnung bekannt, die mindestens einen ersten Kondensator und mindestens einen weiteren, mit dem ersten Kondensator elektrisch zusammenwirkenden Schaltungsteil aufweist. Der erste Kondensator umgibt einen Hohlraum ringförmig. Der weitere Schaltungsteil ist zumindest teilweise innerhalb des Hohlraums angeordnet und mit dem ersten Kondensator elektrisch verbunden. Der Kondensator und der weitere Schaltungsteil können auf einer gemeinsamen Kühlplatte angeordnet sein. Auf dem weiteren Schaltungsteil sind elektrische und elektronische Bauelemente angeordnet.

Aus der DE 44 43 498 C1 ist eine elektrische Schaltungsanordnung bekannt, die mindestens einen ersten Kondensator und mindestens einen weiteren, mit dem ersten Kondensator elektrisch zusammenwirkenden Schaltungsteil aufweist. Der erste Kondensator umgibt einen Hohlraum ringförmig. Der weitere Schaltungsteil ist zumindest teilweise innerhalb des Hohlraums angeordnet und mit dem ersten Kondensator elektrisch verbunden. Auf dem weiteren Schaltungsteil sind elektrische und elektronische Bauelemente angeordnet.

Aus der EP 2 672 618 A1 ist eine elektrische Schaltungsanordnung bekannt, die mindestens einen ersten Kondensator und mindestens einen weiteren, mit dem ersten Kondensator elektrisch zusammenwirkenden Schaltungsteil aufweist. Der erste Kondensator umgibt einen Hohlraum ringförmig. Der weitere Schaltungsteil ist zumindest teilweise innerhalb des Hohlraums angeordnet und mit dem ersten Kondensator elektrisch verbunden. Die erste Kondensatoranordnung kann einen zweiten Kondensator aufweisen, der den ersten Kondensator radial außen umgibt.

Aus der WO 2014/205 474 ist bekannt, dass Kondensatoren Sollbruchstellen aufweisen können.

Die Aufgabe der vorliegenden Erfindung besteht darin, eine elektrische Schaltungsanordnung zu schaffen, welche möglichst kompakt aufgebaut ist und eine hohe Stabilität bietet.

Die Aufgabe wird durch eine elektrische Schaltungsanordnung mit den Merkmalen des Anspruchs 1 gelöst. Vorteilhafte Ausgestaltungen der erfindungsgemäßen elektrischen Schaltungsanordnung sind Gegenstand der abhängigen Ansprüche 2 bis 12.

Erfindungsgemäß wird eine elektrische Schaltungsanordnung vorgeschlagen, wobei
- die Schaltungsanordnung mindestens einen ersten Kondensator und mindestens einen weiteren, mit dem ersten Kondensator elektrisch zusammenwirkenden Schaltungsteil aufweist,
- wobei der weitere Schaltungsteil einen Schaltungsträger aufweist, auf dem elektrische und/oder elektronische Bauelemente angeordnet sind,
- der erste Kondensator einen Hohlraum ringförmig umgibt und Bestandteil einer ersten Kondensatoranordnung ist, welche den Hohlraum ringförmig umgibt,
- der weitere Schaltungsteil zumindest teilweise innerhalb des Hohlraums angeordnet ist und mit dem ersten Kondensator elektrisch verbunden ist,
- die erste Kondensatoranordnung Befestigungselemente aufweist, mittels derer die Schaltungsanordnung mechanisch an einem Halteelement befestigbar ist, und
- die erste Kondensatoranordnung auf ihrer dem Hohlraum zugewandten Innenseite und/oder auf ihrer vom Hohlraum abgewandten Außenseite Kontaktelemente aufweist, über die der erste Kondensator von dem weiteren Schaltungsteil elektrisch kontaktierbar ist und die elektrische Schaltungsanordnung dadurch ausgestaltet ist, dass
- der weitere Schaltungsteil Federkontakte zum elektrischen Kontaktieren der Kontaktelemente aufweist und
- die Federkontakte an die Kontaktelemente andrückbar sind, wobei der weitere Schaltungsteil von der ersten Kondensatoranordnung mechanisch stabil gehalten ist.

Der erste Kondensator ist also Bestandteil einer ersten Kondensatoranordnung, welche aufgrund des Umstands, dass sie den weiteren Schaltungsteil ringförmig umgibt, zugleich als Gehäuse für den weiteren Schaltungsteil dienen kann. Der erste Kondensator kann damit im Ergebnis platzsparend Bestandteil des Gehäuses der elektrischen Schaltungsanordnung sein.

Gleiches gilt, soweit vorhanden, auch für weitere Kondensatoren der ersten Kondensatoranordnung. Ferner können die Kontaktelemente beispielsweise als Kontaktfelder ausgebildet sein.

Im einfachsten Fall bildet die erste Kondensatoranordnung im Querschnitt eine konvexe, überall gekrümmte Kurve, beispielsweise einen Kreis (genauer: aufgrund der endlichen Dicke der ersten Kondensatoranordnung einen Kreisring), eine Ellipse oder ein Oval. Alternativ ist es jedoch möglich, dass die erste Kondensatoranordnung im Querschnitt ein Polygon bildet. Die Anzahl an Ecken kann beispielsweise zwischen drei und zwölf liegen, insbesondere zwischen fünf und zehn. Vorzugsweise sind im Falle eines Polygons die Ecken abgerundet. Zwingend ist dies jedoch nicht.

Die vorliegende Erfindung ist besonders einfach dadurch zu realisieren, dass der erste Kondensator als Wickelkondensator ausgebildet ist. Beispiele derartiger Kondensatoren sind Elektrolytkondensatoren bzw. allgemeiner Folienkondensatoren.

Es ist möglich, dass die erste Kondensatoranordnung außer dem ersten Kondensator keine weiteren Schaltungselemente aufweist. Alternativ ist es möglich, dass die erste Kondensatoranordnung mindestens einen zweiten, vorzugsweise ebenfalls als Wickelkondensator ausgebildeten Kondensator aufweist, der den ersten Kondensator radial außen umgibt oder radial innen am ersten Kondensator anliegt. Es ist sogar möglich, dass zusätzlich zum ersten und zum zweiten Kondensator noch mehr Kondensatoren radial (das heißt vom Hohlraum aus gesehen von innen nach außen oder umgekehrt) aufeinanderfolgend vorhanden sind.

Es ist ebenfalls möglich, dass die erste Kondensatoranordnung an ihren Stoßflächen Kontaktstellen aufweist, über die der erste Kondensator von dem weiteren Schaltungsteil elektrisch kontaktierbar ist. Sofern die erste Kondensatoranordnung zusätzlich zum ersten Kondensator auch einen zweiten Kondensator aufweist, ist es auch möglich, dass je einer der beiden Kondensatoren auf die eine und die andere Weise kontaktierbar ist. Ebenso ist es möglich, dass je einer der beiden Anschlüsse des ersten Kondensators auf die eine und die andere Weise kontaktierbar ist.

Im einfachsten Fall weist die erste Kondensatoranordnung an ihrer Außenseite einfach eine glatte, konvexe Oberfläche auf, beispielsweise einen Zylindermantel. Alternativ ist es möglich, dass die erste Kondensatoranordnung an ihrer Außenseite nach radial außen ragende Kühlflächen aufweist. In diesem Fall bildet die erste Kondensatoranordnung im Querschnitt gesehen einen konkav-konvexen Querschnitt aus.

In einer Ausgestaltung der Schaltungsanordnung weist die erste Kondensatoranordnung eine Sollbruchstelle auf.

Das Aufweisen der Sollbruchstelle an der ersten Kondensatoranordnung kann im Fehlerfall vorteilhaft Schäden minimieren. Das stabile Halten des weiteren Schaltungsteils durch die erste Kondensatoranordnung vereinfacht den Aufbau der Schaltungsanordnung.

In einer derzeit besonders bevorzugten Ausgestaltung der Schaltungsanordnung ist vorgesehen,
- dass die Schaltungsanordnung als Zwischenkreisumrichter ausgebildet ist, dem über einen Gleichrichter eine ein- oder mehrphasige Wechselspannung zugeführt wird und von dem über einen Wechselrichter eine ein- oder mehrphasige Wechselspannung abgegeben wird,
- dass zwischen dem Gleichrichter und dem Wechselrichter ein Zwischenkreiskondensator angeordnet ist,
- dass der weitere Schaltungsteil den Gleichrichter und/oder den Wechselrichter des Zwischenkreisumrichters umfasst und
- dass der erste Kondensator Bestandteil des Zwischenkreiskondensators ist.

Es ist möglich, dass die Schaltungsanordnung eine zweite Kondensatoranordnung aufweist, die ihrerseits mindestens einen mit dem Schaltungsteil elektrisch zusammenwirkenden weiteren Kondensator aufweist. In diesem Fall umgibt auch die zweite Kondensatoranordnung den Hohlraum ringförmig. Weiterhin ist in diesem Fall der weitere Schaltungsteil auch mit dem weiteren Kondensator elektrisch verbunden. Die zweite Kondensatoranordnung ist in diesem Fall auf die erste Kondensatoranordnung aufgesetzt und mit dieser befestigt.

Für die weitergehende Ausgestaltung der zweiten Kondensatoranordnung sind die obigen Ausführungen für die erste Kondensatoranordnung und den ersten Kondensator in analoger Weise anwendbar.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: einen Querschnitt durch eine elektrische Schaltungsanordnung längs einer Linie I-I in FIG 2,
- FIG 2: einen Längsschnitt durch die elektrische Schaltungsanordnung von FIG 1 längs einer Linie II-II in FIG 1,
- FIG 3: einen Querschnitt durch eine weitere elektrische Schaltungsanordnung,
- FIG 4: einen Querschnitt durch eine erste Kondensatoranordnung,
- FIG 5: eine perspektivische Detailansicht der Innenseite einer ersten Kondensatoranordnung,
- FIG 6: einen Querschnitt durch die erste Kondensatoranordnung von FIG 5,
- FIG 7: einen Querschnitt durch eine weitere erste Kondensatoranordnung,
- FIG 8: einen Querschnitt durch eine weitere erste Kondensatoranordnung,
- FIG 9: ein Blockschaltbild einer Schaltungsanordnung,
- FIG 10: einen Querschnitt durch eine weitere elektrische Schaltungsanordnung und
- FIG 11: eine Schaltungsanordnung mit mehreren Kondensatoranordnungen.

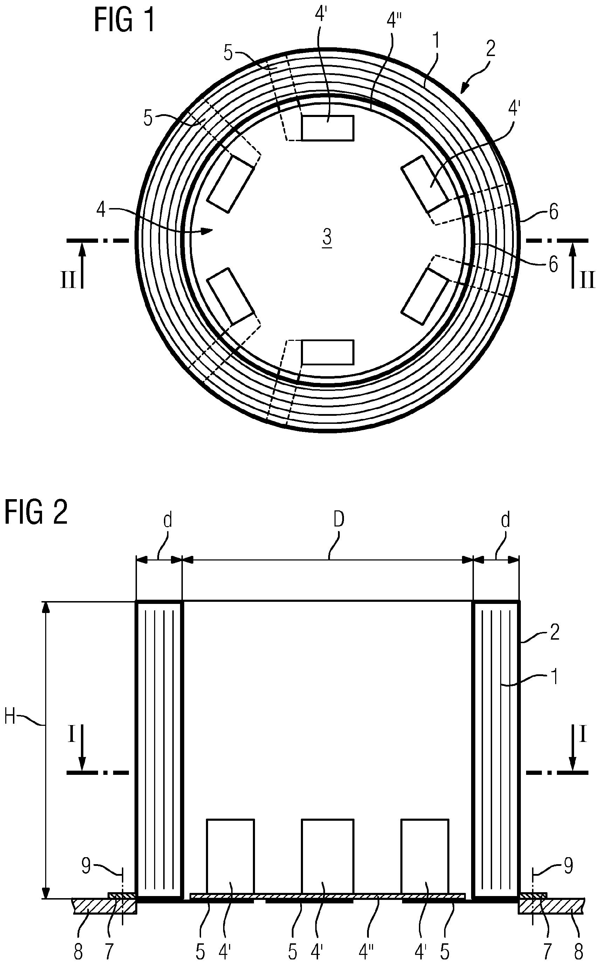

Gemäß den FIG 1 und 2 weist eine elektrische Schaltungsanordnung einen ersten Kondensator 1 auf. Der erste Kondensator 1 ist Bestandteil einer ersten Kondensatoranordnung 2, welche einen Hohlraum 3 ringförmig umgibt. Der erste Kondensator 1 ist vorzugsweise als Wickelkondensator ausgebildet. Wickelkondensatoren sind insbesondere in Form von Folienkondensatoren und Elektrolytkondensatoren allgemein bekannt. Die erste Kondensatoranordnung 2 kann beispielsweise einen Innendurchmesser D aufweisen, der zwischen 8 cm und 50 cm liegt. Die erste Kondensatoranordnung 2 weist weiterhin eine Bauhöhe H auf, die beispielsweise ebenfalls zwischen 8 cm und 50 cm liegt. Eine Wandstärke d liegt in der Regel bei mindestens 5 mm und kann bis zu 3 cm betragen. In Einzelfällen kann von diesen Werten jedoch abgewichen werden.

Innerhalb des Hohlraums 3 ist - zumindest teilweise - mindestens ein weiterer Schaltungsteil 4 angeordnet. Der weitere Schaltungsteil 4 ist vorzugsweise - nicht aber zwingend - radialsymmetrisch aufgebaut oder weist in Umfangsrichtung gesehen zumindest eine gewisse Periodizität auf.

Der mindestens eine weitere Schaltungsteil 4 wirkt mit dem ersten Kondensator 1 elektrisch zusammen. Der weitere Schaltungsteil 4 ist vorzugsweise von der ersten Kondensatoranordnung 2 mechanisch stabil gehalten. Der weitere Schaltungsteil 4 ist weiterhin mit dem ersten Kondensator 1 elektrisch verbunden. Im Rahmen der Ausgestaltung gemäß FIG 1 wird die stabile Halterung des weiteren Schaltungsteils 4 an der ersten Kondensatoranordnung 2 und die elektrische Verbindung mit dem ersten Kondensator 1 durch Kontaktlaschen 5 bewirkt, die einerseits mechanisch mit einer Wandung 6 der ersten Kondensatoranordnung 2 verbunden sind und andererseits elektrisch mit dem ersten Kondensator 1 verbunden sind. Insbesondere können elektrische und elektronische Bauelemente 4', die auf einem Schaltungsträger 4" angeordnet sind, direkt elektrisch mit den Kontaktlaschen 5 verbunden sein (beispielsweise gelötet). Der Schaltungsträger 4" kann in diesem Fall, soweit erforderlich, weitere, nicht dargestellte Bauelemente tragen und/oder Verbindungen der Bauelemente 4' untereinander herstellen.

Zum Herstellen der mechanischen Halterung an der ersten Kondensatoranordnung 2 und der elektrische Verbindung mit dem ersten Kondensator 1 sind auch andere Ausgestaltungen möglich. Beispielsweise kann die Verbindung der Kontaktlaschen 5 mit dem ersten Kondensator 1 ausreichend sein, um auch die mechanische Halterung des weiteren Schaltungsteils 4 zu bewirken.

Die erste Kondensatoranordnung 2 weist weiterhin Befestigungselemente 7 auf. Mittels der Befestigungselemente 7 ist die erste Kondensatoranordnung 2 und mit ihr vorzugsweise zugleich auch die elektrische Schaltungsanordnung als Ganzes mechanisch an einem Halteelement 8 befestigbar. Die Befestigung kann beispielsweise über in FIG 2 schematisch angedeutete Schraubverbindungen 9 erfolgen.

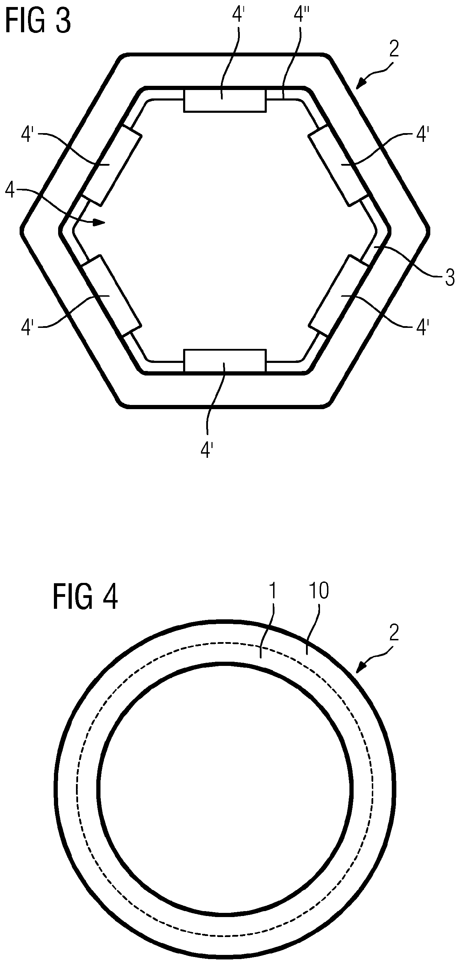

Gemäß der Ausgestaltung der FIG 1 und 2 ist die erste Kondensatoranordnung 2 als Hohlzylinder ausgebildet. Allgemein gesprochen bildet die erste Kondensatoranordnung 2 im Querschnitt eine konvexe, überall gekrümmte Kurve. Alternativen zu einem Kreis sind beispielsweise eine Ellipse oder ein Oval. Diese Ausgestaltungen bieten fertigungstechnische Vorteile. Alternativ kann die erste Kondensatoranordnung entsprechend der Darstellung in FIG 3 im Querschnitt ein Polygon bilden. Diese Ausgestaltung bietet unter Umständen den Vorteil, dass die Bauelemente 4' flächig an der Wandung 6 anliegen können. Dies steht im Gegensatz zur Ausgestaltung der ersten Kondensatoranordnung 2 als Hohlzylinder oder ähnliche überall gekrümmte Struktur. Bei diesen Ausgestaltungen kann die Wölbung der ersten Kondensatoranordnung 2 an ihrer Innenseite entsprechend der Darstellung in FIG 1 unter Umständen bewirken, dass die Bauelemente 4' nur an ihren Kanten die Wandung 6 kontaktieren. Der flächige Kontakt kann beispielsweise auch für eine Kühlung der Bauelemente 4' von Vorteil sein. Auch andere Kontakte, beispielsweise Lötungen und Klebungen können einfacher zu realisieren sein.

Falls die erste Kondensatoranordnung 2 im Querschnitt ein Polygon bildet, sind die Ecken des Polygons vorzugsweise abgerundet. Dies bietet gegenüber scharfen Ecken insbesondere fertigungstechnische Vorteile. Auch aus Gründen des Designs kann diese Ausgestaltung von Vorteil sein. Weiterhin liegt im Falle der Ausgestaltung als Polygon die Anzahl an Ecken vorzugsweise zwischen drei und zwölf, insbesondere zwischen fünf und zehn. Beispielsweise kann sie entsprechend der Darstellung in FIG 3 bei sechs liegen.

Die FIG 1 bis 3 zeigen die einfachste Ausgestaltung, bei welcher die erste Kondensatoranordnung 2 außer dem ersten Kondensator 1 keinen weiteren Kondensator enthält. Es ist jedoch entsprechend der Darstellung in FIG 4 ebenso möglich, dass die erste Kondensatoranordnung 2 einen weiteren Kondensator 10 aufweist, der den ersten Kondensator 1 radial außen umgibt. Der weitere Kondensator 10 wird nachfolgend als zweiter Kondensator 10 bezeichnet. Auch der zweite Kondensator 10 ist - zumindest vorzugsweise - als Wickelkondensator ausgebildet. Ferner kann die erste Kondensatoranordnung 2 - dies ist weder in FIG 4 noch in den weiteren FIG dargestellt - auch noch mehr Kondensatoren umfassen. Die Kondensatoren folgen in diesem Fall radial (also vom Hohlraum aus gesehen von innen nach außen oder umgekehrt) sequenziell aufeinander.

Zur Kontaktierung des weiteren Schaltungsteils 4 mit dem ersten Kondensator 1 (und gegebenenfalls den weiteren Kondensatoren 10 der ersten Kondensatoranordnung 2) sind verschiedene Ausgestaltungen möglich. In Verbindung mit den FIG 1 und 2 wurde bereits eine Ausgestaltung erläutert, bei welcher zu diesem Zweck die Kontaktlaschen 5 vorhanden sind.

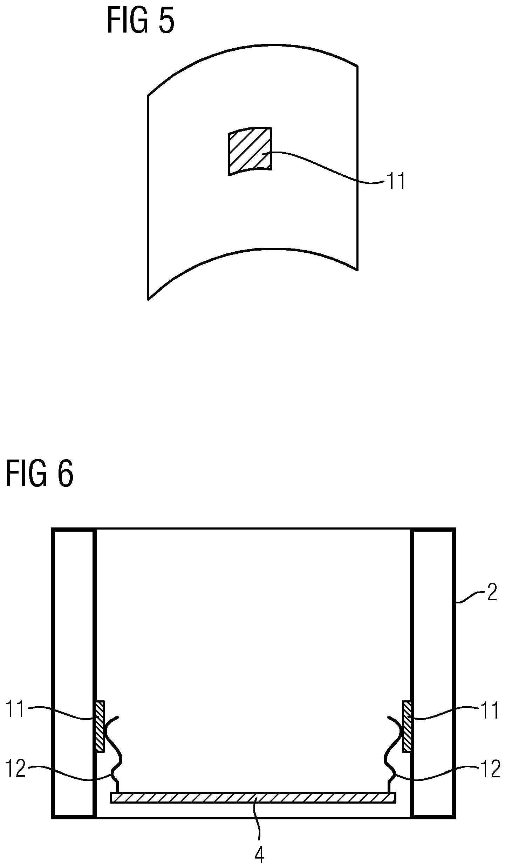

Die erste Kondensatoranordnung 2 weist entsprechend der Darstellung in den FIG 5 und 6 erfindungsgemäß auf ihrer dem Hohlraum 3 zugewandten Innenseite Kontaktelemente 11 auf. Die Kontaktelemente 11 können beispielsweise als Kontaktfelder ausgebildet sein. Dargestellt sind in FIG 5 ein einzelnes Kontaktelement 11 und in FIG 6 zwei Kontaktelemente 11. So ist der erste Kondensator 1 von dem weiteren Schaltungsteil 4 über die Kontaktelemente 11 elektrisch kontaktierbar. Der weitere Schaltungsteil 4 (der in FIG 5 nicht mit dargestellt ist und in FIG 6 nur schematisch angedeutet ist) weist ferner erfindungsgemäß Federkontakte 12 auf, welche an die Kontaktelemente 11 angedrückt werden und dadurch die Kontaktelemente 11 elektrisch kontaktieren. Unter Umständen können die Kontaktelemente 11 in der Wandung 6 vertieft angeordnet sein oder von einem umlaufenden Rand umgeben sein. Durch die Federkontakte 12 wird auch eine hinreichend stabile mechanische Verbindung des weiteren Schaltungsteils 4 erreicht.

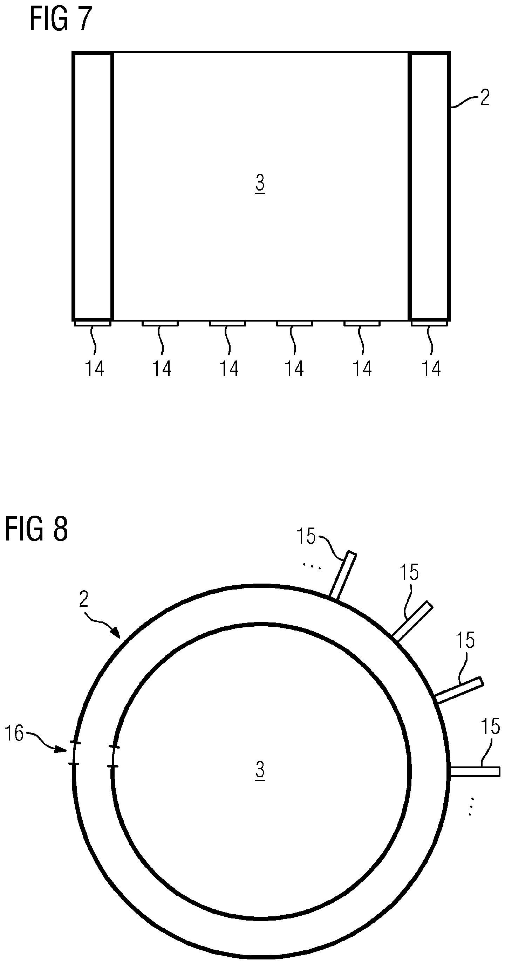

Ebenso ist es entsprechend der Darstellung in FIG 7 möglich, dass die erste Kondensatoranordnung 2 an ihren Stoßflächen 13 Kontaktstellen 14 aufweist. In diesem Fall kann der erste Kondensator 1 von dem weiteren Schaltungsteil 4 über die Kontaktstellen 14 elektrisch kontaktiert werden. Die Kontaktstellen 14 können beispielsweise in die bereits in Verbindung mit den FIG 1 und 2 erwähnten Kontaktlaschen 5 übergehen. Auch ist es möglich, dass die erste Kondensatoranordnung 2 an ihren Stoßflächen 13 Steckerstifte und/oder Steckerbuchsen zur Aufnahme von Steckerstiften aufweist. Auch andere Ausgestaltungen sind möglich.

FIG 8 zeigt zwei weitere Ausgestaltungen der ersten Kondensatoranordnung 2. Diese beiden Ausgestaltungen sind unabhängig voneinander realisierbar. Weiterhin sind diese beiden Ausgestaltungen bei jeder der bisher erläuterten Ausgestaltungen realisierbar.

Gemäß FIG 8 weist die erste Kondensatoranordnung 2 an ihrer Außenseite Kühlflächen 15 auf. Die Kühlflächen 15 ragen nach radial außen, also von der ersten Kondensatoranordnung 2 weg. Die Richtung, in welcher die Kühlflächen 15 sich erstrecken, kann hierbei eine leichte Tangentialkomponente (also um die erste Kondensatoranordnung 2 herum) und/oder eine leichte Axialkomponente aufweisen. Die erste Kondensatoranordnung 2 weist aufgrund der Kühlflächen 15 im Querschnitt gesehen eine konkav-konvexe Kontur auf. Dies steht im Gegensatz zu einer Ausgestaltung ohne Kühlflächen. In diesem Fall würde die erste Kondensatoranordnung 2 im Querschnitt gesehen eine rein konvexe Kontur aufweisen. Weiterhin weist die erste Kondensatoranordnung 2 gemäß FIG 8 eine Sollbruchstelle 16 auf.

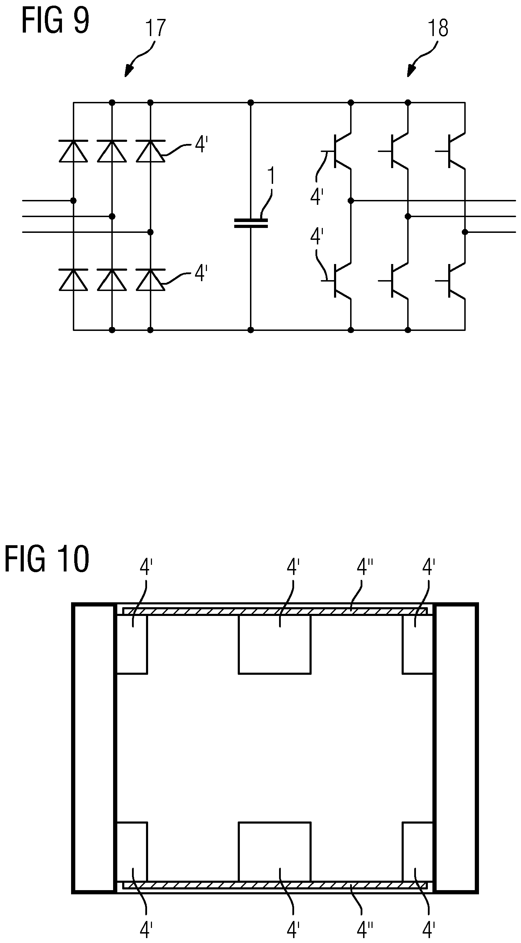

In funktional-elektrischer Hinsicht kann die Schaltungsanordnung nach Bedarf ausgebildet sein. Beispielsweise kann die Schaltungsanordnung entsprechend der Darstellung in FIG 9 als Zwischenkreisumrichter ausgebildet sein. Dem Zwischenkreisumrichter wird in diesem Fall über einen Gleichrichter 17 eine Wechselspannung zugeführt. Die zugeführte Wechselspannung kann entsprechend der Darstellung in FIG 9 mehrphasig sein. Alternativ kann es sich um eine einphasige Wechselspannung handeln. Der Gleichrichter 17 kann alternativ ein ungesteuerter Gleichrichter (Diodengleichrichter) oder ein gesteuerter und damit rückspeisefähiger Gleichrichter sein. Von dem Zwischenkreisumrichter wird weiterhin über einen Wechselrichter 18 eine Wechselspannung abgegeben. Die abgegebene Wechselspannung kann - analog zur zugeführten Wechselspannung - entsprechend der Darstellung in FIG 9 mehrphasig sein. Alternativ kann es sich um eine einphasige Wechselspannung handeln. Zwischen dem Gleichrichter 17 und dem Wechselrichter 18 ist weiterhin, wie allgemein üblich, ein Zwischenkreiskondensator 19 angeordnet.

Der weitere Schaltungsteil 4 kann insbesondere den Gleichrichter 17 umfassen. Alternativ kann der weitere Schaltungsteil 4 den Wechselrichter 18 umfassen. Auch kann der weitere Schaltungsteil 4 sowohl den Gleichrichter 17 als auch den Wechselrichter 18 umfassen. Insbesondere können die Bauelemente 4' des weiteren Schaltungsteils 4 mit den Halbleiterschaltern des Gleichrichters 17 und/oder des Wechselrichters 18 korrespondieren. Der erste Kondensator 1 wiederum kann insbesondere der Zwischenkreiskondensator sein oder Bestandteil des Zwischenkreiskondensators sein.

Insbesondere im Falle eines Zwischenkreisumrichters bietet sich eine Ausgestaltung der ersten Kondensatoranordnung 2 als Polygon mit drei, vier, fünf, sechs, acht, zehn oder zwölf Ecken an.

Eine - in den FIG nicht dargestellte - Ausgestaltung mit drei Ecken bietet sich beispielsweise an, wenn sowohl die zugeführte als auch die abgegebene Wechselspannung dreiphasig sind und eine Vollbrückengleichrichtung und eine Vollbrückenwechselrichtung erfolgen. In diesem Fall können beispielsweise zwei weitere Schaltungsteile 4 vorhanden sein, von denen je eines den Gleichrichter 17 und den Wechselrichter 18 umfasst und an jeder Seite des Polygons je zwei Halbleiterschalter angeordnet sind. Die beiden Schaltungsteile 4 sind in diesem Fall in verschiedenen Ebenen des Hohlraums 3 angeordnet. Alternativ können in einer einzigen Ebene an jeder Seite des Polygons je vier Halbleiterschalter angeordnet sein.

Eine Ausgestaltung mit vier Ecken bietet sich beispielsweise an, wenn sowohl die zugeführte als auch die abgegebene Wechselspannung einphasig sind und eine Vollbrückengleichrichtung und eine Vollbrückenwechselrichtung erfolgen. In diesem Fall können beispielsweise zwei weitere Schaltungsteile 4 vorhanden sein, von denen je eines den Gleichrichter 17 und den Wechselrichter 18 umfasst. Die beiden Schaltungsteile 4 sind in diesem Fall, wie in FIG 10 schematisch angedeutet, in verschiedenen Ebenen des Hohlraums 3 angeordnet. Alternativ können in einer einzigen Ebene an jeder Seite des Polygons je zwei Halbleiterschalter angeordnet sein.

Eine Ausgestaltung mit fünf Ecken bietet sich beispielsweise an, wenn die zugeführte Wechselspannung einphasig ist, die abgegebene Wechselspannung dreiphasig ist und eine Vollbrückengleichrichtung und eine Vollbrückenwechselrichtung erfolgen. In diesem Fall können beispielsweise zwei weitere Schaltungsteile 4 vorhanden sein, von denen jedes zwei Halbleiterschalter des Gleichrichters 17 und drei Halbleiterschalter des Wechselrichters 18 umfasst. Die beiden Schaltungsteile 4 sind auch in diesem Fall, analog zu FIG 10, in verschiedenen Ebenen des Hohlraums 3 angeordnet. Eine analoge Ausgestaltung ist möglich, wenn umgekehrt die zugeführte Wechselspannung dreiphasig ist, die abgegebene Wechselspannung einphasig ist und eine Vollbrückengleichrichtung und eine Vollbrückenwechselrichtung erfolgen. Alternativ können in einer einzigen Ebene an jeder Seite des Polygons je zwei Halbleiterschalter angeordnet sein.

Eine Ausgestaltung mit sechs Ecken bietet sich beispielsweise an, wenn sowohl die zugeführte als auch die abgegebene Wechselspannung dreiphasig sind und eine Vollbrückengleichrichtung und eine Vollbrückenwechselrichtung erfolgen. In diesem Fall können beispielsweise zwei weitere Schaltungsteile 4 vorhanden sein, von denen je eines den Gleichrichter 17 und den Wechselrichter 18 umfasst. Die beiden Schaltungsteile 4 sind in diesem Fall, analog zu FIG 10, in verschiedenen Ebenen des Hohlraums 3 angeordnet. Alternativ können in einer einzigen Ebene an jeder Seite des Polygons je zwei Halbleiterschalter angeordnet sein.
Eine Ausgestaltung mit acht Ecken bietet sich beispielsweise an, wenn sowohl die zugeführte als auch die abgegebene Wechselspannung einphasig sind und eine Vollbrückengleichrichtung und eine Vollbrückenwechselrichtung erfolgen. In diesem Fall kann beispielsweise ein einziger Schaltungsteil 4 vorhanden sein, welcher sowohl den Gleichrichter 17 als auch den Wechselrichter 18 umfasst. Der Schaltungsteil 4 ist in diesem Fall, analog zur Darstellung in FIG 2, in einer einzigen Ebene des Hohlraums 3 angeordnet.

Eine Ausgestaltung mit zehn Ecken bietet sich beispielsweise an, wenn die zugeführte Wechselspannung einphasig ist, die abgegebene Wechselspannung dreiphasig ist und eine Vollbrückengleichrichtung und eine Vollbrückenwechselrichtung erfolgen. In diesem Fall kann beispielsweise ein einziger Schaltungsteil 4 vorhanden sein, welcher sowohl den Gleichrichter 17 als auch den Wechselrichter 18 umfasst. Der Schaltungsteil 4 ist in diesem Fall, analog zur Darstellung in FIG 2, in einer einzigen Ebene des Hohlraums 3 angeordnet. Eine analoge Ausgestaltung ist möglich, wenn umgekehrt die zugeführte Wechselspannung dreiphasig ist, die abgegebene Wechselspannung einphasig ist und eine Vollbrückengleichrichtung und eine Vollbrückenwechselrichtung erfolgen.

Eine Ausgestaltung mit zwölf Ecken bietet sich beispielsweise an, wenn sowohl die zugeführte als auch die abgegebene Wechselspannung dreiphasig sind und eine Vollbrückengleichrichtung und eine Vollbrückenwechselrichtung erfolgen. In diesem Fall kann beispielsweise ein einziger Schaltungsteil 4 vorhanden sein, welcher sowohl den Gleichrichter 17 als auch den Wechselrichter 18 umfasst. Der Schaltungsteil 4 ist in diesem Fall, analog zur Darstellung in FIG 2, in einer einzigen Ebene des Hohlraums 3 angeordnet.

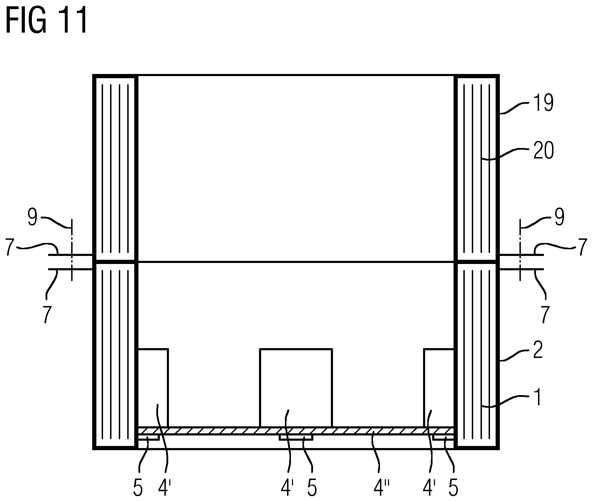

In Verbindung mit FIG 4 wurde erläutert, dass eine einzelne Kondensatoranordnung - nämlich die erste Kondensatoranordnung 2 - mehrere Kondensatoren 1, 10 aufweisen kann. Ebenso ist es entsprechend der Darstellung in FIG 11 möglich, dass die elektrische Schaltungsanordnung zusätzlich zur ersten Kondensatoranordnung 2 eine zweite Kondensatoranordnung 19 aufweist. Auch die zweite Kondensatoranordnung 19 weist ihrerseits mindestens einen Kondensator 20 auf, nachfolgend als weiterer Kondensator 20 bezeichnet. Auch der weitere Kondensator 20 wirkt mit dem Schaltungsteil 4 elektrisch zusammen. Der weitere Schaltungsteil 4 ist zu diesem Zweck auch mit dem weiteren Kondensator 20 elektrisch verbunden. Die Verbindung mit dem weiteren Kondensator 20 kann entweder direkt oder indirekt über die erste Kondensatoranordnung 2 realisiert sein. Weiterhin umgibt auch die zweite Kondensatoranordnung 19 den Hohlraum 3 ringförmig. Insbesondere ist die zweite Kondensatoranordnung 19 entsprechend der Darstellung in FIG 11 auf die erste Kondensatoranordnung 2 aufgesetzt und mit dieser befestigt.

Bezüglich der weiteren Ausgestaltung der zweiten Kondensatoranordnung 19 und des weiteren Kondensators 20 sind die gleichen Ausgestaltungen möglich, die obenstehend bezüglich der ersten Kondensatoranordnung 2 und des ersten Kondensators 1 erläutert wurden.

Zusammengefasst betrifft die vorliegende Erfindung somit folgenden Sachverhalt:
Eine elektrische Schaltungsanordnung weist mindestens einen ersten Kondensator 1 und mindestens einen weiteren, mit dem ersten Kondensator 1 elektrisch zusammenwirkenden Schaltungsteil 4 auf. Der erste Kondensator 1 ist Bestandteil einer ersten Kondensatoranordnung 2, welche einen Hohlraum 3 ringförmig umgibt. Der weitere Schaltungsteil 4 ist zumindest teilweise innerhalb des Hohlraums 3 angeordnet und mit dem ersten Kondensator 1 elektrisch verbunden. Die erste Kondensatoranordnung 2 weist Befestigungselemente 7 auf, mittels derer die Schaltungsanordnung mechanisch an einem Halteelement 8 befestigbar ist. Weiterhin weist die erste Kondensatoranordnung eine Sollbruchstelle 16 auf und ist der weitere Schaltungsteil 4 von der ersten Kondensatoranordnung 2 mechanisch stabil gehalten.

Die vorliegende Erfindung weist viele Vorteile auf. So kann der erste Kondensator 1 sehr nahe an den Bauelementen 4' angeordnet werden. Eine Leitungslänge kann also minimiert werden. Dadurch ergeben sich zugleich auch niedrige intrinsische Induktivitäten von Verbindungsleitungen. Diese Aussage gilt in analoger Weise auch für die zweiten Kondensatoren 10 und die Kondensatoren 20 der zweiten Kondensatoranordnung 19. Es sind hohe Kapazitäten in unmittelbarer Nähe von schaltenden Elementen (Bauelemente 4') realisierbar. Die erste Kondensatoranordnung 2 ist leicht in Wickeltechnik zu fertigen. Durch die Integration der Gehäusefunktion in die erste Kondensatoranordnung 2 (und gegebenenfalls weitere Kondensatoranordnungen 19) können zusätzliche Bauteile und damit Kosten und Bauraum eingespart werden. Aufgrund der großen Oberfläche der ersten Kondensatoranordnung 2 kann diese gut gekühlt werden. Aufgrund der großen Kapazität, die mit einem einzelnen Kondensator - dem ersten Kondensator 1 - erreicht werden kann, entfallen viele einzelne Kondensatoren mit kleinerer Kapazität und deren Anschlüsse. Die erste Kondensatoranordnung 2 weist eine hohe Eigenstabilität auf und ist dadurch in der Lage, den weiteren Schaltungsteil 4 mechanisch zu halten und zu stützen. Das Vorsehen einer Sollbruchstelle 16 ermöglicht es, gezielt die Umgebung der Schaltungsanordnung oder die Schaltungsanordnung selbst gegen eine Gefährdung durch einen Defekt des ersten Kondensators 1 (oder eines anderen Kondensators 10 der Kondensatoranordnung 2) zu schützen. Die erfindungsgemäße Ausgestaltung verbessert zugleich auch die EMV-Eigenschaften der Schaltungsanordnung. Soweit erforderlich, können mehrere Kondensatoranordnungen 1, 19 - gegebenenfalls auch mit unterschiedlicher Bauform, Größe und Kapazität - elektrisch und mechanisch gekoppelt werden. Die Baugröße und die Kapazität können somit nach Bedarf skaliert werden. Es ist sogar möglich, die Kondensatoranordnungen 1, 19 ausschließlich mechanisch miteinander zu verbinden, so dass unabhängig voneinander verbindbare Kondensatoren 1, 10, 20 zur Verfügung stehen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Elektrische Schaltungsanordnung,
- wobei die Schaltungsanordnung mindestens einen ersten Kondensator (1) und mindestens einen weiteren, mit dem ersten Kondensator (1) elektrisch zusammenwirkenden Schaltungsteil (4) aufweist,
- wobei der weitere Schaltungsteil (4) einen Schaltungsträger (4") aufweist, auf dem elektrische und/oder elektronische Bauelemente (4') angeordnet sind,
- wobei der erste Kondensator (1) einen Hohlraum (3) ringförmig umgibt und Bestandteil einer ersten Kondensatoranordnung (2) ist, welche den Hohlraum (3) ringförmig umgibt,
- wobei der weitere Schaltungsteil (4) zumindest teilweise innerhalb des Hohlraums (3) angeordnet ist und mit dem ersten Kondensator (1) elektrisch verbunden ist,
- wobei die erste Kondensatoranordnung (2) Befestigungselemente (7) aufweist, mittels derer die Schaltungsanordnung mechanisch an einem Halteelement (8) befestigbar ist und,
- wobei die erste Kondensatoranordnung (2) auf ihrer dem Hohlraum (3) zugewandten Innenseite und/oder auf ihrer vom Hohlraum (3) abgewandten Außenseite Kontaktelemente (11) aufweist, über die der erste Kondensator (1) von dem weiteren Schaltungsteil (4) elektrisch kontaktierbar ist,
**dadurch gekennzeichnet, dass**
- der weitere Schaltungsteil (4) Federkontakte (12) zum elektrischen Kontaktieren der Kontaktelemente (11) aufweist und- die Federkontakte (12) an die Kontaktelemente (11) andrückbar sind, wobei der weitere Schaltungsteil (4) von der ersten Kondensatoranordnung (2) mechanisch stabil gehalten ist.

2. Schaltungsanordnung nach Anspruch 1,
**dadurch gekennzeichnet,**
**dass** die erste Kondensatoranordnung (2) im Querschnitt eine konvexe, überall gekrümmte Kurve bildet, beispielsweise einen Kreis, eine Ellipse oder ein Oval.

3. Schaltungsanordnung nach Anspruch 1,
**dadurch gekennzeichnet,**
**dass** die erste Kondensatoranordnung (2) im Querschnitt ein Polygon bildet.

4. Schaltungsanordnung nach Anspruch 3,
**dadurch gekennzeichnet,**
**dass** die Anzahl an Ecken zwischen drei und zwölf liegt, insbesondere zwischen fünf und zehn.

5. Schaltungsanordnung nach einem der obigen Ansprüche,
**dadurch gekennzeichnet,**
**dass** der erste Kondensator (1) als Wickelkondensator ausgebildet ist.

6. Schaltungsanordnung nach Anspruch 5,
**dadurch gekennzeichnet,**
**dass** die erste Kondensatoranordnung (2) mindestens einen zweiten, vorzugsweise ebenfalls als Wickelkondensator ausgebildeten Kondensator (10) aufweist, der den ersten Kondensator (1) radial außen umgibt oder radial innen am ersten Kondensator (1) anliegt.

7. Schaltungsanordnung nach einem der obigen Ansprüche,
**dadurch gekennzeichnet,**
**dass** die erste Kondensatoranordnung (2) an ihren Stoßflächen (13) Kontaktstellen (14) aufweist, über die der erste Kondensator (1) von dem weiteren Schaltungsteil (4) elektrisch kontaktierbar ist.

8. Schaltungsanordnung nach einem der obigen Ansprüche,
**dadurch gekennzeichnet,**
**dass** die erste Kondensatoranordnung (2) an ihrer Außenseite nach radial außen ragende Kühlflächen (15) aufweist.

9. Schaltungsanordnung nach einem der obigen Ansprüche,
**dadurch gekennzeichnet,**
**dass** die erste Kondensatoranordnung (2) eine Sollbruchstelle (16) aufweist.

10. Schaltungsanordnung nach einem der obigen Ansprüche,
**dadurch gekennzeichnet,**
- **dass** die Schaltungsanordnung als Zwischenkreisumrichter ausgebildet ist, dem über einen Gleichrichter (17) eine ein- oder mehrphasige Wechselspannung zugeführt wird und von dem über einen Wechselrichter (18) eine ein- oder mehrphasige Wechselspannung abgegeben wird,
- **dass** zwischen dem Gleichrichter (17) und dem Wechselrichter (18) ein Zwischenkreiskondensator angeordnet ist,
- **dass** der weitere Schaltungsteil (4) den Gleichrichter (17) und/oder dem Wechselrichter (18) des Zwischenkreisumrichters umfasst und
- **dass** der erste Kondensator (1) Bestandteil des Zwischenkreiskondensators ist.

11. Schaltungsanordnung nach einem der obigen Ansprüche,
**dadurch gekennzeichnet,**
- **dass** die Schaltungsanordnung eine zweite Kondensatoranordnung (19) aufweist, die ihrerseits mindestens einen mit dem Schaltungsteil (4) elektrisch zusammenwirkenden weiteren Kondensator (20) aufweist,
- **dass** auch die zweite Kondensatoranordnung (19) den Hohlraum (3) ringförmig umgibt,
- **dass** der weitere Schaltungsteil (4) auch mit dem weiteren Kondensator (20) elektrisch verbunden ist und
- **dass** die zweite Kondensatoranordnung (19) auf die erste Kondensatoranordnung (2) aufgesetzt und mit dieser befestigt ist.

12. Schaltungsanordnung nach Anspruch 11,
**dadurch gekennzeichnet,**
**dass** die zweite Kondensatoranordnung (19) und der weitere Kondensator (20) so ausgebildet sind, wie dies in den Ansprüchen 2 bis 7, 9 und 10 für die erste Kondensatoranordnung (2) und den ersten Kondensator (1) ausgeführt ist.

## Claims

1. Electrical circuit arrangement,
- wherein the circuit arrangement has at least one first capacitor (1) and at least one further circuit part (4) which electrically interacts with the first capacitor (1),
- wherein the further circuit part (4) has a circuit carrier (4"), on which electrical and/or electronic components (4') are arranged,
- wherein the first capacitor (1) surrounds a cavity (3) in an annular manner and is an integral part of a first capacitor arrangement (2), which surrounds the cavity (3) in an annular manner,
- wherein the further circuit part (4) is arranged at least partially within the cavity (3) and is electrically connected to the first capacitor (1),
- wherein the first capacitor arrangement (2) has securing elements (7), by means of which the circuit arrangement can be secured mechanically to a holding element (8) and
- wherein the first capacitor arrangement (2) has contact elements (11) on its interior facing the cavity (3) and/or on its exterior facing away from the cavity (3), by way of which the first capacitor (1) can make electrical contact with the further circuit part (4),
**characterised in that**
- the further circuit part (4) has spring contacts (12) for making electrical contact with the contact elements (11) and
- the spring contacts (12) can be pressed against the contact elements (11), wherein the further circuit part (4) is held in a mechanically stable manner by the first capacitor arrangement.

2. Circuit arrangement according to claim 1,
**characterised in that**
the first capacitor arrangement (2) forms a convex, overall curvilinear curve in the cross-section, for instance a circle, an ellipse or an oval.

3. Circuit arrangement according to claim 1,
**characterised in that**
the first capacitor arrangement (2) forms a polygon in the cross-section.

4. Circuit arrangement according to claim 3,
**characterised in that**
the number of corners is between three and twelve, in particular between five and ten.

5. Circuit arrangement according to one of the preceding claims,
**characterised in that**
the first capacitor (1) is embodied as a winding capacitor.

6. Circuit arrangement according to claim 5,
**characterised in that**
the first capacitor arrangement (2) has at least one second capacitor (10), preferably likewise embodied as a winding capacitor, which radially surrounds the first capacitor (1) on the outside or rests on the first capacitor (1) radially on the inside.

7. Circuit arrangement according to one of the preceding claims,
**characterised in that**
the first capacitor arrangement (2) has contact points (14) on its abutting surfaces (13), by way of which the first capacitor (1) can be electrically contacted by the further circuit part (4).

8. Circuit arrangement according to one of the preceding claims,
**characterised in that**
the first capacitor arrangement (2) has cooling surfaces (15) on its exterior that project radially outward.

9. Circuit arrangement according to one of the above claims, **characterised in that**
the first capacitor arrangement (2) has a rated break point (16) .

10. Circuit arrangement according to one of the preceding claims,
**characterised in that**
- the circuit arrangement is embodied as an intermediate circuit converter, to which a single- or multi-phase alternating voltage is supplied by way of a rectifier (17) and from which a single- or multi-phase alternating voltage is output by way of an inverter (18),
- an intermediate circuit capacitor is arranged between the rectifier (17) and the inverter (18),
- the further circuit part (4) comprises the rectifier (17) and/or the inverter (18) of the intermediate circuit converter and
- the first capacitor (1) is an integral part of the intermediate circuit capacitor.

11. Circuit arrangement according to one of the preceding claims,
**characterised in that**
- the circuit arrangement has a second capacitor arrangement (19), which in turn has at least one further capacitor (20) which interacts electrically with the circuit part (4),
- the second capacitor arrangement (19) also surrounds the cavity (3) in an annular manner,
- the further circuit part (4) is also electrically connected to the further capacitor (20) and
- the second capacitor arrangement (19) is attached to the first capacitor arrangement (2) and is secured hereto.

12. Circuit arrangement according to claim 11,
**characterised in that**
the second capacitor arrangement (19) and the further capacitor (20) are embodied as described in claims 2 to 7, 9 and 10 for the first capacitor arrangement (2) and the first capacitor (1).

## Revendications

1. Agencement de circuit électrique,
- dans lequel l'agencement de circuit a au moins un premier condensateur (1) et au moins une autre partie (4) de circuit coopérant électriquement avec le premier condensateur (1),
- dans lequel l'autre partie (4) de circuit a un support (4") de circuit, sur lequel sont disposés des composants (4') électriques et/ou électroniques,
- dans lequel le premier condensateur (1) entoure annulairement une cavité (3) et fait partie d'un premier agencement de condensateur, qui entoure annulairement la cavité (3),
- dans lequel l'autre partie (4) de circuit est disposée, au moins en partie, dans la cavité (3) et est reliée électriquement au premier condensateur (1),
- dans lequel le premier agencement (2) de condensateur a des éléments (7) de fixation, au moyen desquels l'agencement de circuit peut être fixé mécaniquement à au moins un élément (8) de retenue et,
- dans lequel le premier agencement (2) de condensateur a, sur son côté intérieur, tourné vers la cavité (3), et/ou sur son côté extérieur, loin de la cavité (3), des éléments (11) de contact, par lesquels le premier condensateur (1) peut être mis en contact électrique par l'autre partie (4) de circuit,
**caractérisé en ce que**
- l'autre partie (4) de circuit a des contacts (12) à ressort pour la mise en contact électrique des éléments (11) de contact et les contacts (12) à ressort peuvent être pressés sur les éléments (11) de contact, l'autre partie (4) de circuit étant retenue de manière stable mécaniquement par le premier agencement (2) de condensateur.

2. Agencement de circuit suivant la revendication 1,
**caractérisé**
**en ce que** le premier agencement (2) de condensateur forme en section transversale une courbe convexe incurvée partout, par exemple un cercle, une ellipse ou un ovale.

3. Agencement de circuit suivant la revendication 1,
**caractérisé**
**en ce que** le premier agencement (2) de condensateur forme en section transversale un polygone.

4. Agencement de circuit suivant la revendication 3,
**caractérisé**
**en ce que** le nombre de sommets est compris entre trois et douze, en étant notamment compris entre cinq et dix.

5. Agencement de circuit suivant l'une des revendications précédentes,
**caractérisé**
**en ce que** le premier condensateur (1) est constitué en condensateur bobiné.

6. Agencement de circuit suivant la revendication 5,
**caractérisé**
**en ce que** le premier agencement (2) de condensateur a au moins un deuxième condensateur (10), de préférence également sous la forme d'un condensateur bobiné, qui entoure à l'extérieur radialement le premier condensateur (1) ou s'applique à l'intérieur radialement au premier condensateur (1).

7. Agencement de circuit suivant l'une des revendications précédentes,
**caractérisé**
**en ce que** le premier agencement (2) de condensateur a, sur ses faces (13) d'about, des points (14) de contact, par lesquels le premier condensateur (1) peut être mis en contact électrique avec l'autre partie (4) de circuit.

8. Agencement de circuit suivant l'une des revendications précédentes,
**caractérisé**
**en ce que** le premier agencement (2) de condensateur a, sur son côté extérieur, des faces (15) de refroidissement faisant saillie vers l'extérieur radialement.

9. Agencement de circuit suivant l'une des revendications précédentes,
**caractérisé**
**en ce que** le premier agencement (2) de condensateur a un point (16) destiné à se rompre.

10. Agencement de circuit suivant l'une des revendications précédentes,
**caractérisé**
- **en ce que** l'agencement de circuit est constitué sous la forme d'un convertisseur à circuit intermédiaire, auquel une tension alternative, monophasée ou polyphasée, est appliquée par un redresseur (17) et duquel une tension alternative monophasée ou polyphasée est cédée par l'intermédiaire d'un onduleur (18),
- **en ce qu'**un condensateur de circuit intermédiaire est monté entre le redresseur (17) et l'onduleur (18),
- **en ce que** l'autre partie (4) de circuit comprend le redresseur (17) et/ou l'onduleur (18) du redresseur à circuit intermédiaire et
- **en ce que** le premier condensateur (1) fait partie du condensateur de circuit intermédiaire.

11. Agencement de circuit suivant l'une des revendications précédentes,
**caractérisé**
- **en ce que** l'agencement de circuit a un deuxième agencement (19) de condensateur, qui a pour sa part au moins un autre condensateur (20) coopérant électriquement avec la partie (4) de circuit,
- **en ce que** le deuxième agencement (19) de condensateur entoure annulairement également la cavité (3),
- **en ce que** l'autre partie (4) de circuit est reliée électriquement également à l'autre condensateur (20) et
- **en ce que** le deuxième agencement (19) de condensateur est mis sur le premier agencement (2) de condensateur et y est fixé.

12. Agencement de circuit suivant la revendication 11,
**caractérisé**
**en ce que** le deuxième agencement (19) de condensateur et l'autre condensateur (20) sont constitués comme cela est expliqué dans les revendications 2 à 7, 9 et 10 pour le premier agencement (2) de condensateur et le premier condensateur (1).
